# EUROPEAN PATENT APPLICATION

(11) **EP 0 779 516 A1**
(43) Date of publication of application: **18.06.1997**
(21) Application number: 96906777.6
(22) Date of filing: 26.03.1996
(51) Int. Cl.: G01R 21/02

(54) **THERMOELECTRIC SENSOR INTENDED TO MEASURE THE TRUE EFFECTIVE CURRENT**

(30) Priority: 07.04.1995 ES 9500694
(71) Applicant: Infrarrojo y Microelectronica S.L., 28760 Tres Cantos (ES)
(72) Inventor: RUIZ SANCHEZ, Manuel, E-28020 Madrid (ES); RUIZ ROBLES, Manuel, E-28020 Madrid (ES)
(74) Representative: Garcia Cabrerizo, Francisco
(86) International application number: ES9600065
(87) International publication number: WO9631784

(57) **Abstract**

It measures the true effective value of a current by comparing the thermic effects produced by the current to be measured and a known comparison current, over two heating resistors, one being a measuring (5) and the other a comparison (6) resistor, through a circuit composed by in-series thermoelectric couples (1), so that each pair of joints in electrical opposition is heated by the thermic flow coming from each of the heaters - the measurement (5) and the comparison (6) heaters - generating an electromotive power in its terminals - an error signal - representing the current disparity which, once amplified and handled by an electronic subsystem - establishes a negative feedback which automatically adjusts the value of the comparison current which annuls said electromotive power, thereby establishing the equality between the effective value of the comparison current - a known value - and the effective value of the current to be measured, allowing for automatic electrical consumption calculations and their transmission through a telematic applications interface.

## Description

### OBJECT OF THE INVENTION

This specification refers to an invention patent concerning a true effective current thermoelectric sensor, the main purpose of which is to measure, with a required precision, the effective value of the electric current circulating through an electric network or circuit in order to establish both the electric power and the energy consumption, within a period of time, by loads of a known power factor.

### FIELD OF THE INVENTION

This invention is related to the sector of measurement instrument techniques.

Its field of application is in next generation consumption digital counters specially adapted to manage electric consumption measurement, handling, display and transmission data in homes and factories through a telematic applications interface designed to facilitate a rational management of electric energy consumption and its automatic invoicing. It is therefore applicable to individual devices or power outlets integrated, for instance, in electric home appliances (heaters, electric stoves, ovens, ...), in the hotel management trade (automatic consumption invoicing for weekly rental apartments, camping grounds, marina mooring power outlets, ...) or as an external connecting element between the main network and the electric appliances in order to reflect electric consumption within a given period of time, either in kW-hours or directly in monetary units.

A further field of application is in telematics, wherein the consumption measured by the integrated sensor is transmitted for central management and electric consumption automatic invoicing (e.g. through automatic debiting in a bank or credit card account).

Another field of application is that of instrumentation, where true effective currents or voltages must be measured accurately within a wide dynamic margin (e.g. polymeters or radioelectric power meters in directional couplers), or that of applications wherein the frequency spectrum of the current to be measured is exceedingly wide, precluding effective current measurements through other techniques (radioelectric power meters by means of power directional couplers or energy supplied by inverters via batteries), since one of the potential features of the proposed sensor consists in its large band width.

### BACKGROUND OF THE INVENTION

The actual estimate of the effective value of a voltage through the Joule effect and the measurement of its thermic effects by means of a temperature sensor is a known technique which is appreciated for its accuracy, and is frequently used for calibrating instruments which fail to positively measure the effective value. Exact measurements require comparison between the thermic effects - generated by the current to be measured, regardless of its form - over a calibrated resistor with the thermic effects generated by a direct current over the same resistor. The equalization of the thermic effects is obtained from a temperature measurement through a thermistor or thermoelectric couple. Once the value of the direct current producing the same thermic effects on the same resistor is established, this is regarded as the effective value of the current being measured.

However, known methods carry out measurements based exclusively on conduction phenomena, namely heat diffusion, which involves greater response time constants, and normally uses the same resistor to carry out the comparison, which makes the measuring system more complex by increasing the response time and its cost, while reducing its reliability. An example of this type of system is described in US patent 4 274 142, "Recirculating rms ac conversion method and apparatus".

The Spanish invention patent application P9400683, "Self-calibrated digital current sensor", based on electromagnetic principles, solves the problems inherent to effective current measurements in non-lineal loads (e.g., alternate current consumption in resistive loads regulated through electronic means). This invention, which no doubt represents an improvement, has an adequate cost for energy tariff applications or other professional applications requiring reactive power and power factor measurements, although it is too high for other applications - for example, incorporating it as a domestic electric appliance component informing the user about the electrical consumption during a given period of time, or as applied to a given range of polymeters.

### DESCRIPTION OF THE INVENTION

The proposed true effective current thermoelectric sensor solves the problems inherent to the complexities of the comparison method, providing for facility of construction and precision of the temperature-sensitive element, based on the Seebeck effect, implemented through thick-layer electrolytic deposition techniques or thin-sheet deposition techniques on a thin sheet, allowing for full fabrication in the form of a microsystem - through either hybrid or monolithic technology - resulting in a reduction of the production costs and an increase in the final reliability of the microsystem.

The proposed true effective current thermoelectric sensor is based on the comparison of the thermic effect generated over an electric heating resistor by a current whose effective value is to be measured, with the thermic effect generated over another electric heating resistor - referred to as being for comparative purposes - having the same characteristics as the former, by means of a direct current whose value constitutes a measure of the true effective value of said current. Comparison of the thermic effects is implemented by annulling the value of the electromotive power generated by a thermopile, a so-called error signal, made up of several series-connected thermoelectric couples in which the even (or odd) joint or joints are heated by one of said heaters, while the odd (or even) joint or joints are heated by the other heater. These joint heating processes are conducted through the effect of the heat flows coming from the measurement and comparison heaters.

The equalizing of the thermic effects indicates that the effective value of the current being measured is the same as the effective value of the comparison current. This equalizing of the thermic effects is achieved through negative feedback governed by a regulation algorithm acting on the comparison current, the error signal becoming annulled.

Obviously, there are other ways of measuring the thermic effect balance in both heaters by electronic means, as for instance by generating a current ramp in the comparison heater while the electromotive power generated by the thermoelectric couples governs a comparator which fluctuates when the error signal passes through zero or some other preset value. In turn, this signal provided by the comparator governs the electronic control system which memorizes the value of the ramp current causing the comparator to become activated, this being a measure of the current's effective value. Likewise, ways of sensing the temperature differences in two heaters have been described in the past through the effects generated in the base-emitter joints of two transistors performed over a floating silicon membrane fabricated by anisotropic printing on a silicon dice, the main drawback, in addition to its high production cost, being the errors caused by derivations in time of the sensitive element, the dispersions inherent to the process of producing the temperature-sensitive semiconductor device and the low reliability inherent to the mechanical fatigue originating from the thermic expansion and contraction of the fragile electric conductors deposited on the floating silicon membrane.

The proposed true effective current thermoelectric sensor is based on the automatic comparison and equalizing of the thermic effect generated by a current being measured (which may have an unknown wave-shape) and a known comparison current - by balancing the thermoelectric effects induced by the thermic actions of the calorific flows transmitted either by radiation, conduction or both forms of propagation - respectively generated by two heaters, one being a measurement and the other a comparison heater, over the joints in opposition of two or more in-series thermoelectric couples made by electrolytic deposit, vacuum evaporation or cathode spraying techniques, or some other conventional means, and by selectively printing the conductor by conventional photolithography techniques, thus providing the system's sensitive element. The proposed invention unites the reproduction capability and the stability of both the Joule effect and the Seebeck effect to provide a true effective current sensing device which solves the problems inherent to precision, stability, reliability and fabrication facility, being produced by means of conventional conductor sheet deposit and printing techniques and having a very competitive production cost as compared to other possible alternatives.

Thus, the concept of the proposed true effective current thermoelectric sensor allows for production by means of conventional large-scale microelectronic manufacturing techniques, with low unitary production costs and a high level of reliability, since the invention proposed may be embodied through standard deposit and printing techniques to finally constitute the full microsystem through a hybrid or even a monolithic technology, enabling production on a large scale at a very low cost.

### DESCRIPTION OF THE DRAWINGS

To complete this description and in order to help in providing a better understanding of the characteristics of the invention, three drawing sheets are attached to this specification, being an integral part thereof, wherein the following is displayed with an illustrative, non-limiting character:
Figure 1 shows a form of putting the concept of the invention into practice, reflecting the detail of an elementary cell composed of two thermoelectric joints in opposition and the means of transmission of the thermic effects generated in the heating and comparison resistors.
Figure 2 shows a form of increasing the effectivity of the process by increasing the number of in-series thermoelectric joints.
Figure 3 shows a form of interconnecting the measuring resistors to one another and the comparison resistors to one another, and also shows a possible thermoelectric joint shape.
Figure 4 shows a form of putting the concept of the invention into practice by using the sensor system comprising the two thermoelectric couples, the heating resistors and the microcontroller and its associated electronic components.

### PREFERRED EMBODIMENT OF THE INVENTION

In the light of these figures, the true effective current thermoelectric sensor is seen to be shaped on the basis of a form of putting into practice the concept described herein.

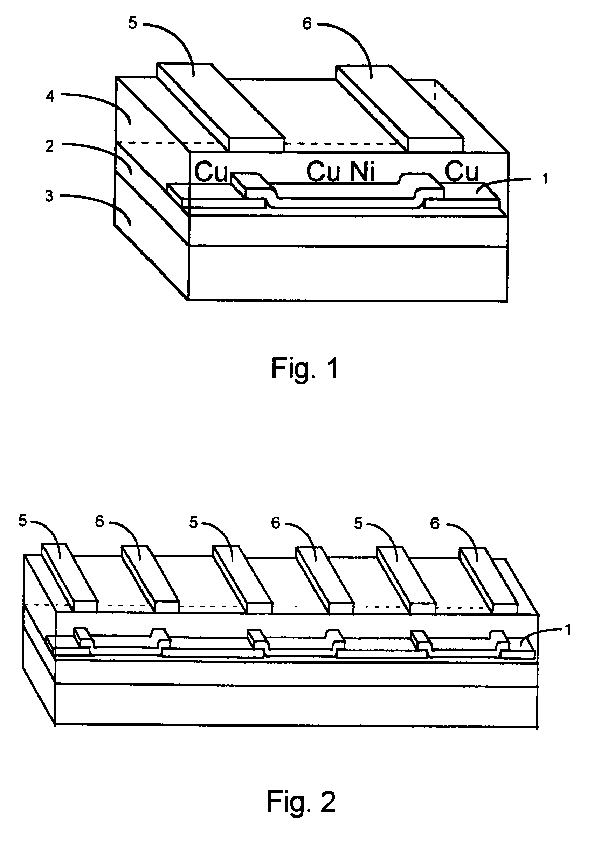

Figure 1 shows the detail of a elementary cell composed of two copper (Cu)-constantan (CuNi)-copper (Cu) joints (1) connected in series and which act electrically in opposition for an equal-sign rise of both their temperatures. Both joints, composed of two thermoelectric couples in opposition, are constructed by means of thick layer or thin layer technology over a silicon substrate (3), being separated by an isolating layer (2) - for example, SiO₂ - or else directly over an electrically isolating substrate (3). Said thermoelectric couples are embedded in a layer of material which is transparent to infrared radiation (4) - for example, SiOₓ - deposited through high vacuum evaporation technology or other suitable microelectronic technology, vapor phase chemical deposition, for example, or by separating the heaters by a layer of electrically insulating material (4) allowing the passage of thermic flow. Immediately after the thermoelectric couple layer (1), and before depositing said SiOₓ layer (4), it is worthwhile depositing a thin layer of electrically insulating material over which in turn is deposited a thin layer of infrared radiation absorbent material, e.g. spongy gold, designed to obtain a high absorption coefficient. These two layers are not shown in the drawing for the sake of simplicity and easy understanding. The function of these two layers is to transform the radiation striking the thermoelectric couples in a temperature rise of the latter when the thermic flow transmission is either by radiation or conduction, or else by both conduction mechanisms simultaneously. Should both these layers not be deposited, the radiation striking the metal surfaces of the thermoelectric couples, of a low absorption coefficient, would be partly reflected, thereby reducing the incident radiation transformation effect with a temperature rise, in which case the device operates mainly by thermic flow transmitted by conduction. Immediately after the layer transparent to radiation (4), the corresponding resistive elements, the measuring heater (5) - though which circulates the current to be measured - and the comparison heater (6) - through which circulates the comparison direct current - are deposited.

Figure 2 shows a detail which reveals a larger number of in-series thermoelectric couples (1), as well as the measurement heating elements (5) and the comparison heating elements (6).

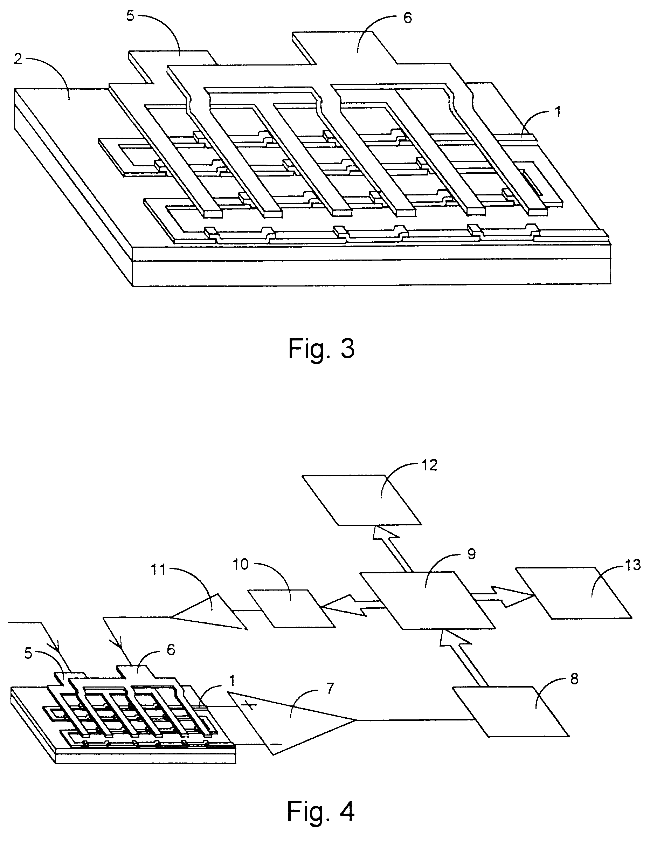

Figure 3 shows a view which reveals a form of arranging the thermoelectric couples in series over the substrate (2) in order to make up the thermoelectric couple circuit (1), as well as a form of interconnecting the measuring heaters (5) between each other and the comparison heaters (6) between each other.

Figure 4 shows the operational diagram of the true effective current thermoelectric sensor. In the thermoelectric couple (1) circuit terminals appears an electromotive force which is dependent on the temperatures of both heaters, the measuring (5) and the comparison (6) heaters, and consequently also on the effective values of the current circulating through the measurement heater (5) and the comparison current circulating through the comparison heater (6). Figure 4 reveals how this potential difference in the thermoelectric couple (1) circuit terminals is amplified by the preamplifier (7) and transformed into a digital signal by the digital analog converter (8), to be handled by the measurement and regulation algorithms in the microcontroller (9), which sends a digital signal to the analog converter (10) to be transformed into a voltage governing the amplifier (11), which injects the comparison current into the comparison heater (6). In this way, through negative feedback, the system reaches its balance when the thermic effects generated by the measuring and comparison currents over both heaters - measurement (5) and comparison (6), respectively - are equalized, annulling the error voltage generated by the thermoelectric couple (1) circuit.

The comparison heater (6) current digital control value represents the value of the effective current that is being measured, provided the value of the error signal sensed by the thermoelectric couple circuit is practically nonexistent. The comparison heater (6) current value is known, since it is controlled by the microcontroller (9).

The values of the efficient current readings are handled by the microcontroller (9) in order to obtain the value of the electric power consumed as from the mains voltage value, further obtaining, through its integration in time, the electrical consumption values in kW-hours. These consumption measurement values are sent by the microcontroller (9) to the interface (12) for display, and on to the communications interface (13) for transmission.

The electrical consumption values are stored in the non-volatile memory (i.e., EEPROM) of the microcontroller (9) from time to time.

## Claims

1. True effective current thermoelectric sensor, characterized in that it includes:
A resistive means for transforming the electric current being measured into calorific energy through the Joule effect, and this in turn into a temperature rise in said means, a function of the value of said current. A resistive means for transforming a comparison electric current - of a known effective value - into calorific energy through the Joule effect, and this in turn into a temperature rise in said means. A means for transmitting thermic energies, respectively a function of the temperatures of the two above mentioned means. A means constituted by an in-series thermoelectric couple circuit which transforms the thermic energies generated by the measurement current and the comparison current into a temperature rise in the joints adjacent the thermoelectric couples - in electrical opposition - which in turn is transformed into electromotive power, a function of the temperature thereof, and whose total resulting value in the thermoelectric couple circuit terminals - the error signal - is a function of the values of the measurement and comparison currents. A means of governing the comparison current in order to annul the error signal. A means of determining the annulment of the error signal supplied by the thermoelectric couple circuit. A means of performing electrical consumption calculations based on the value of the measured true effective current and the electric network voltage. A means of presenting the calculations of the electrical consumption. A means of transmitting the information through the network or to a computer, using a communications interface.

2. True effective current thermoelectric sensor, according to the first claim, characterized in that the current being measured generates, in a resistive means and through the Joule effect, a calorific energy flow which determines the temperature rise of the even (or odd) joints of a thermopile composed of in-series thermoelectric couples, while a known comparison current generates, in another resistive means and through the Joule effect, a calorific energy flow which determines the temperature rise of the odd (or even) joints in the thermopile, so that the disparity between the measuring current and the comparison current is transformed into a disparity in the temperatures of the thermoelectric couples in electrical opposition and - through the thermoelectric effect - into electromotive forces resulting in an electric signal - total electromotive power - which represents the error signal, namely, the disparity between the measurement and comparison currents. The annulment of said error signal is achieved through negative feedback governing the comparison current, at which time the measuring current - the value of which is needed to be known - is identical to the comparison current - of a known value -, the value of the comparison current being handled for transmission and display.

3. True effective current thermoelectric sensor, according to the first claim, characterized in that the value of the electric power supplied to resistive loads, or of a known power factor, is determined by multiplying, through electronic means, the value of the effective current by the value of the effective voltage of the electrical network supplying the energy, this power value being corrected by the value of the known power factor.

4. True effective current thermoelectric sensor, according to the third claim, characterized in that the electric energy supplied to resistive loads, or of a known power factor, is determined by integrating in time, through electronic means, the electric power determined by the procedure established in the previous claim.

5. True effective current thermoelectric sensor, characterized in that it performs a calculation, in kW-hours or in monetary units, of the consumption of electrical home appliances or individual current outlets, allowing the users of the individual electric energy consumed in a given period of time to take a reading in either energy units or monetary units, and making the automatic management and invoicing easier by transmitting this information through a telematic applications interface.
